# EUROPEAN PATENT SPECIFICATION

(11) **EP 2 343 779 B1**
(45) Date of publication and mention of the grant of the patent: **09.05.2018**
(21) Application number: 11155422.6
(22) Date of filing: 02.07.2008
(51) Int. Cl.: B65D 75/12, H01Q 1/36, H01Q 1/44, H01Q 7/00, H01Q 23/00, G06K 19/077, H01Q 1/22

(54) **WIRELESS IC DEVICE AND COMPONENT FOR WIRELESS IC DEVICE**
DRAHTLOSE IC-VORRICHTUNG UND KOMPONENTE FÜR DRAHTLOSE IC-VORRICHTUNG
DISPOSITIF CI SANS FIL ET COMPOSANT POUR LE DISPOSITIF CI SANS FIL

(30) Priority: 19.09.2007 JP 2007241819; 14.04.2008 JP 2008105188; 04.07.2007 JP 2007176360; 31.01.2008 WO PCT/JP2008/051521
(43) Date of publication of application: 13.07.2011
(62) Divisional of application: 08777756.1
(73) Proprietor: Murata Manufacturing Co., Ltd., Kyoto 617-8555 (JP)
(72) Inventor: Kato, Noboru, Kyoto 617-8555 (JP); Ikemoto, Nobuo, Kyoto 617-8555 (JP)
(74) Representative: Stöckeler, Ferdinand

(56) References cited:
- EP-A1- 1 772 927
- EP-A1- 1 953 867
- EP-A2- 1 613 134
- WO-A1-98/40930
- DE-A1- 19 516 227
- KR-B1- 100 705 359
- US-A1- 2003 020 568
- US-A1- 2005 001 785
- US-A1- 2005 179 604
- US-A1- 2006 043 198
- US-A1- 2006 163 368
- US-A1- 2007 052 613
- US-B1- 6 181 287

## Description

### Technical Field

The present invention relates to a wireless IC device used for a radio frequency identification (RFID) system that performs data communication in a noncontact manner through electromagnetic waves, and a component for the wireless IC device.

### Background Art

In recent years, an article management system has been using an RFID system which includes a reader/writer that generates an induction field and a wireless IC device that stores predetermined information allocated to an article, and noncontact communication is established between the reader/writer and the wireless IC device to transmit the information therebetween.

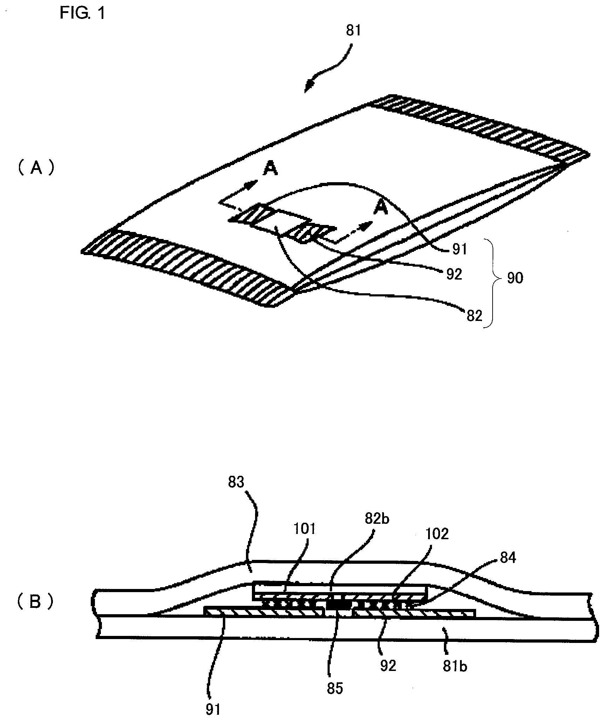

FIG. 1 are a views that show an example of a noncontact IC tag (wireless IC device) in which an IC tag label is attached to an IC tag antenna, which is described in Patent Document 1. FIG. 1(A) is a plan view. FIG. 1(B) is an enlarged cross-sectional view taken along the line A-A in FIG. 1(A). The noncontact IC tag antenna is formed of two separated antenna patterns 91 and 92. The antenna patterns 91 and 92 each are formed of a layer of metal thin films.

Antennas 101 and 102 are formed on a label base material 82b of the noncontact IC tag label 82, and an IC chip 85 is mounted thereon. The antennas 101 and 102 of the noncontact IC tag label 82 are attached to be in contact with the antenna patterns 91 and 92 via an anisotropic conductive adhesive 84 to thereby form a noncontact IC tag 90.

A sealant film 83 is laminated on the label base material 82b to prevent peeling of the IC tag label, and finally an IC tag attached package 81 is formed.
Patent Document 1: Japanese Unexamined Patent Application Publication No. 2003-243918

### Disclosure of Invention

### Problems to be Solved by the Invention

The noncontact IC tag of Patent Document 1 and the package provided with the noncontact IC tag have the following problems.
(a) Because antenna patterns are formed in a process different from the process in which a package is formed, a process of producing an antenna is required. This causes the process to be prolonged and requires an additional member to thereby increase production costs for the package.
(b) To obtain a sufficient radiation characteristic, it is necessary to increase the size of the antenna pattern, and, therefore, it is difficult to attach a tag to a small article.
(c) Because a tag is formed on the base material of an article and another film covers the formation face of the tag, the thickness of the IC tag formation portion increases.

US 2006/043198 A1 discloses an RFID device, such as an RFID tag or label. The RFID device includes a combined reactive coupler electrically coupling a transponder chip to an antenna. The combined reactive coupler includes a magnetic coupler and a capacitive coupler. The magnetic coupler and the reactive coupler may have respective coupling elements on both the interposer and on an antenna substrate.

US 2007/52613 A1 teaches an RFID transponder having a microchip or integrated circuit, an impedance-matching structure and a resonant structure mounted on at least one substrate and connected to each other by an electric field.

EP 1 772 927 A1 discloses an antenna unit having a antenna. A T-shaped cutout portion is formed in the antenna and the periphery of the cutout portion forms an impedance matching wiring portion. Connecting regions of the antenna, which are left and right of the cutout portion, are connected to connecting ends of an IC module comprising an IC chip. The IC chip may be connected directly to the antenna.

US 2005/179604 A1 discloses an antenna including a plurality of discrete loop antennas disposed concentrically on a substrate. Each one of the plurality of loop antennas is electrically isolated from each other one of said plurality of loop antennas.

US 2005/001785 A1 discloses a radio frequency identification (RIFD) inlay including an electrical connection between a chip and an antenna. The electrical connection includes conductive interposer leads and a capacitive connection. The capacitive connection may involve putting the antenna and the interposer leads into close proximity, with dielectric pads therebetween, to allow capacitive coupling between the antenna and the interposer leads.

US 2003/0020568 A1 discloses a stacked dielectric filter including a filter section which has first and second input side resonant electrodes and first and second output side resonant electrodes of two 1/4 wavelength resonators, a converting section which has a plurality of strip lines, and a connecting section which connects the filter section and the converting section, wherein the filter section, the converting section, and the connecting section are formed in a dielectric substrate. DE 19516227 A1 discloses a RFID chip using a small loop antenna arranged within and in the center of a large loop antenna.

KR 100705359 B1 discloses a RFID tag with a loop antenna coupled to a planar radiator divided in two halves.

Then, it is an object of the invention to provide a wireless IC device that eliminates the above problems, reduces production costs for a package, enables attachment to a small article, and suppresses the thickness of the tag formation portion.

### Means for Solving the Problems

To solve the above problems, the invention provides an article according to claim 1.

According to the above configuration, for example, processes or members for forming an antenna pattern shown in FIG. 1 on an article are unnecessary. Thus, there is almost no increase in cost for providing a wireless IC device for an article.

In addition, because the entire or portion of the article may be utilized as a radiator, a sufficient radiation characteristic may be obtained even when it is attached to a small article.

Furthermore, because the thickness of a portion on a base material of the article, at which the high-frequency device is provided, may be reduced, a protrusion of the high-frequency device portion may be suppressed and, therefore, an appearance is not influenced.

Moreover, by using the electromagnetic coupling module, impedance matching between the wireless IC chip and the radiation electrode may be designed within the power supply circuit substrate. Thus, it is not necessary to limit the shape or material of the radiation electrode, and it may be applied to any articles. The wireless IC device of the invention includes a loop electrode provided at a mounting portion (adjacent to a mounting area) at which the high-frequency device is mounted, wherein the loop electrode is coupled to the high-frequency device and is electromagnetically coupled to the radiation electrode via an insulating layer. According to the above configuration, it is possible to easily match the high-frequency device with the loop electrode, and the loop electrode is insulated from the radiation electrode in terms of direct current, so that it is possible to enhance resistance against static electricity.

A matching circuit is provided between the mounting portion of the high-frequency device and the loop electrode, wherein the matching circuit directly electrically connects the high-frequency device with the loop electrode. According to the above configuration, the matching circuit may be utilized as an inductor for matching an impedance between the radiation electrode and the high-frequency device. Thus, the degree of freedom for designing impedance matching for a wireless IC device is increased, and, in addition, the design becomes easy.

A resonant circuit and/or a matching circuit is provided in the power supply circuit substrate. According to the above configuration, selectivity of frequency increases. Thus, the operating frequency of the wireless IC device may be mostly determined using the self-resonant frequency. In accordance with the above, it is possible to transfer (exchange) energy of a signal having a frequency used in an RFID system with high efficiency. This may improve the radiation characteristic of the wireless IC device.

In addition, by providing the matching circuit in the power supply circuit substrate, it is possible to transfer (exchange) energy of a signal having a frequency used in an RFID system with high efficiency.

A resonant frequency of the resonant circuit substantially corresponds to a frequency of a signal exchanged by the radiation electrode.

By so doing, the radiation electrode is simply coupled to a power supply circuit portion and just needs to have a size corresponding to a necessary gain. It is not necessary to limit the shape or material of the radiation electrode depending on a frequency used, and it may be applied to any articles.

The radiation electrode is, for example, a metal film layer of an article package such that a sheet having a conductive layer is formed into a bag-like shape or a package-like shape. According to the above configuration, an article package having a metal film layer may be utilized without any change, and almost the entire article operates as a radiator. Even when a plurality of articles are overlapped, the ID of each article may be read.

The radiation electrode is an electrode pattern formed, for example, on a circuit substrate in an electronic device. According to the above configuration, the circuit substrate provided in the electronic device may be utilized without any change, and mounting of the high-frequency device becomes easy.

The radiation electrode is a metal plate provided on a rear face of a component, such as a liquid crystal display panel, in an electronic device. According to the above configuration, the component provided in the electronic device may be utilized without any change, and the size and cost are not increased.

A resonant conductor that has a resonant frequency that is equal to an operating frequency of the high-frequency device or a frequency close to the operating frequency is provided, wherein the resonant conductor is coupled to the high-frequency device. According to the above configuration, a radiation gain at the operating frequency of an RFID tag increases, and an excellent characteristic is obtained as an RFID. In addition, because the resonant frequency of the resonant conductor is not influenced by components mounted on the printed wiring substrate, design is easy.

The resonant conductor is arranged substantially parallel to an edge portion of the radiation electrode, at which the cutout portion is formed. According to the above configuration, coupling between the resonant conductor and the radiation electrode becomes strong and, therefore, a high gain characteristic may be obtained.

The resonant conductor has a length that is substantially equal to a side of the radiation electrode, which the resonant conductor is located adjacent to. According to the above configuration, coupling between the resonant conductor and the radiation electrode becomes strong and, therefore, a high gain characteristic may be obtained.

The resonant conductor is arranged so that portion of the resonant conductor, located adjacent to a position at which the high-frequency device is arranged, is substantially located at the center. According to the above configuration, coupling between the resonant conductor and the high-frequency device becomes strong and, therefore, a high gain characteristic may be obtained.

A plurality of the high-frequency devices are provided, and the resonant conductor is coupled to each of the high-frequency devices. According to the above configuration, the number of necessary resonant conductors may be reduced, and the occupied area on the printed wiring substrate may be reduced. Thus, manufacturing cost may be reduced.

The resonant conductor is separable from a body that forms the radiation electrode. According to the above configuration, in the manufacturing process, a communication distance with a reader/writer may be kept long, and after manufacturing, the size of the printed wiring substrate is not increased. In addition, it is possible to provide communication as needed by bringing it close to the reader/writer.

A casing of a device, on which the wireless IC device is mounted, or another component mounted on the device also serves as the resonant conductor. According to the above configuration, it is possible to obtain a necessary gain even with a metal case or a mounted component.

A component for a wireless IC device includes: a high-frequency device, which is an electromagnetic coupling module or a wireless IC, formed of a wireless IC and a power supply circuit substrate that is electrically connected or electromagnetically coupled to the wireless IC while being coupled to an external circuit; and a substrate on which the high-frequency device is mounted and which includes at least two linear electrodes, one ends of which are coupled to the high-frequency device.

According to the above configuration, if the article only has a conductor that operates as a radiator, by just assembling the component for a wireless IC device to that article, the article may be utilized as an RFID tag attached article. The other ends of the linear electrodes are electrically connected to each other to form a loop electrode. According to the above configuration, the loop shape formed by the loop electrode is not influenced by assembling, such as soldering and, therefore, highly accurate design with less fluctuations in impedance, or the like, may be achieved. The article has a radiation electrode that is electrically connected to the other ends of the at least two linear electrodes to form a loop electrode. According to the above configuration, it is possible to easily form an RFID tag attached article. The article is provided with a conductor that is coupled to the loop electrode and operates as a radiator. According to the above configuration, it is possible to easily form an RFID tag attached article. In addition, when the article is an electronic component, it is possible to reduce variations in characteristic thereof.

### Advantages

According to the invention, the following advantageous effects are obtained. for example, processes or members for forming an antenna pattern shown in FIG. 1 on an article are unnecessary. Thus, there is almost no increase in cost for providing a wireless IC device for an article.

In addition, because the entire or portion of the article may be utilized as a radiator, a sufficient radiation characteristic may be obtained even when it is attached to a small article.

Furthermore, because the thickness of a portion on a base material of the article, at which the high-frequency device is provided, may be reduced, a protrusion of the high-frequency device portion may be suppressed and, therefore, an appearance is not influenced.

Moreover, by using the electromagnetic coupling module, impedance matching between the wireless IC chip and the radiation electrode may be designed within the power supply circuit substrate. Thus, it is not necessary to limit the shape or material of the radiation electrode, and it may be applied to any articles.

### Brief Description of Drawings

[FIG. 1] FIG. 1 is a view that shows the configuration of a wireless IC device described in Patent Document 1.
[FIG. 2] FIG. 2 is a view that shows the configuration of a wireless IC device according to a first example and the configuration of an article provided with the wireless IC device.
[FIG. 3] FIG. 3 is a configuration diagram of the wireless IC device, showing only a relevant portion of the article shown in FIG. 2.
[FIG. 4] FIG. 4 is a view that shows the configuration of a wireless IC device according to a first embodiment and the configuration of an article provided with the wireless IC device.
[FIG. 5] FIG. 5 is a configuration diagram of the wireless IC device, showing only a relevant portion of the article shown in FIG. 3.
[FIG. 6] FIG. 6 is a view that shows the configuration of a wireless IC device according to a second example and the configuration of an article provided with the wireless IC device.
[FIG. 7] FIG. 7 is a view that shows the configuration of a wireless IC device according to a third example and the configuration of an article provided with the wireless IC device.
[FIG. 8] FIG. 8 is a center cross-sectional view that is taken along the line passing a main portion of the wireless IC device and a partially enlarged plan view of the main portion of the wireless IC device.
[FIG. 9] FIG. 9 is a view that shows the configuration of a wireless IC device according to a second embodiment.
[FIG. 10] FIG. 10 is an external perspective view of an electromagnetic coupling module 1 used for a wireless IC device according to a third embodiment.
[FIG. 11] FIG. 11 is an exploded view of the internal configuration of a power supply circuit substrate of an electromagnetic coupling module.
[FIG. 12] FIG. 12 is an equivalent circuit diagram that includes the power supply circuit substrate and a cutout portion of a metal film.
[FIG. 13] FIG. 13 is a view that shows the configuration of a wireless IC device and the configuration of an article provided with the wireless IC device according to a fourth embodiment.
[FIG. 14] FIG. 14 is a cross-sectional view of a main portion of the wireless IC device.
[FIG. 15] FIG. 15 is an exploded perspective view of a power supply circuit substrate of a wireless IC device according to an fifth embodiment.
[FIG. 16] FIG. 16 is an equivalent circuit diagram of a main portion of the wireless IC device.
[FIG. 17] FIG. 17 is a plan view of an electromagnetic coupling module used for a wireless IC device according to a sixth embodiment.
[FIG. 18] FIG. 18 is a view that shows the configuration of a wireless IC device according to a seventh embodiment.
[FIG. 19] FIG. 19 is a view that shows some configurations of a wireless IC devices according to an eighth embodiment.
[FIG. 20] FIG. 20 is a view that shows the configuration of another wireless IC device according to the eighth embodiment.
[FIG. 21] FIG. 21 is a view that shows some configurations of further another wireless IC device according to the eighth embodiment.
[FIG. 22] FIG. 22 is a view that shows the configuration of a wireless IC device according to a ninth embodiment.
[FIG. 23] FIG. 23 is a view that shows some configurations of a wireless IC device according to a tenth embodiment.
[FIG. 24] FIG. 24 is a plan view that shows the configuration of a wireless IC device according to a eleventh embodiment.
[FIG. 25] FIG. 25 is a plan view that shows the configuration of a wireless IC device according to a twelfth embodiment.
[FIG. 26] FIG. 26 is a plan view that shows the configuration of a wireless IC device according to a thirteenth embodiment.
[FIG. 27] FIG. 27 is a perspective view of a cellular phone terminal provided with a wireless IC device according to a fourteenth embodiment and a cross-sectional view of a main portion of an internal circuit substrate.
[FIG. 28] FIG. 28 is a plan view that shows the configuration of a component for a wireless IC device according to an fifteenth embodiment.
[FIG. 29] FIG. 29 is a plan view that shows a wireless IC device that uses the component for a wireless IC device according to a fourth example.
[FIG. 30] FIG. 30 is a view that shows an example in which a main portion of a wireless IC device is formed within a ground electrode formation area on a printed wiring substrate 80.
[FIG. 31] FIG. 31 is a plan view that shows the configuration of a component for a wireless IC device according to a sixteenth embodiment and the configuration of a wireless IC device provided with that component.
[FIG. 32] FIG. 32 is a plan view that shows the configuration of a component for a wireless IC device according to a fifth example.
[FIG. 33] FIG. 33 is a plan view that shows the configuration of a wireless IC device provided with the component for a wireless IC device according to the fifth example.
[FIG. 34] FIG. 34 is a plan view that shows the configuration of a component 113 for a wireless IC device according to a seventeenth embodiment.

### Reference Numerals

1, 2, 3 electromagnetic coupling module
4 power supply circuit substrate
5 wireless IC chip
6 main portion of wireless IC device
7 loop electrode
8 radiation electrode
10 base material
11 substrate
12 loop electrode
13 printed wiring substrate
15 circuit substrate
16 electrode pattern
17, 18 electronic component
20 inductor electrode
21 molded resin
25 capacitor electrode
30 loop electrode
35a to 35d wireless IC chip mounting land
40 power supply circuit substrate
41A to 41H dielectric layer
42a via hole
45a, 45b inductor electrode
46, 47 inductor electrode
51 capacitor electrode
53 to 57 capacitor electrode
60 article package
61 cutout portion
62 non-conductive portion
63 metal plane body
64 insulative sheet
65 metal film
66 cutout portion
67 matching circuit
68 resonant conductor
69 metal film (ground conductor)
70 to 73 article
80 printed wiring substrate
81 mounted side conductor component (resonant conductor)
82 process line installed conductor(resonant conductor)
111, 112, 113 component for wireless IC device
C1 capacitor
C2 capacitor
L1, L2 inductor
E electric field
H magnetic field

### Best Modes for Carrying Out the Invention

### First Example

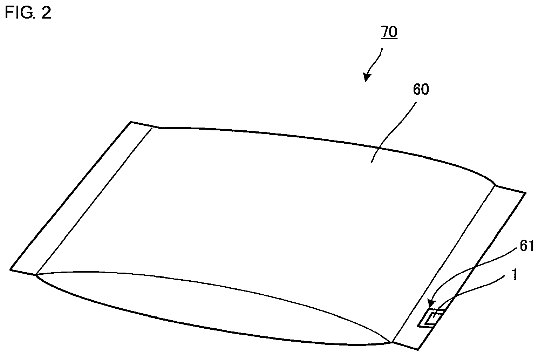

FIG. 2 is an external perspective view that shows the configuration of a wireless IC device according to a first example and the configuration of an article provided with the wireless IC device. The article 70 is, for example, a packed snack, such as a packed potato chips. An article package 60 is a package that is formed so that an aluminum-deposited laminated film is formed into a bag-like shape.

A cutout portion (portion at which aluminum is not vapor-deposited) 61 is formed at an edge portion of the article package 60, and an electromagnetic coupling module 1 is arranged in the cutout portion 61.

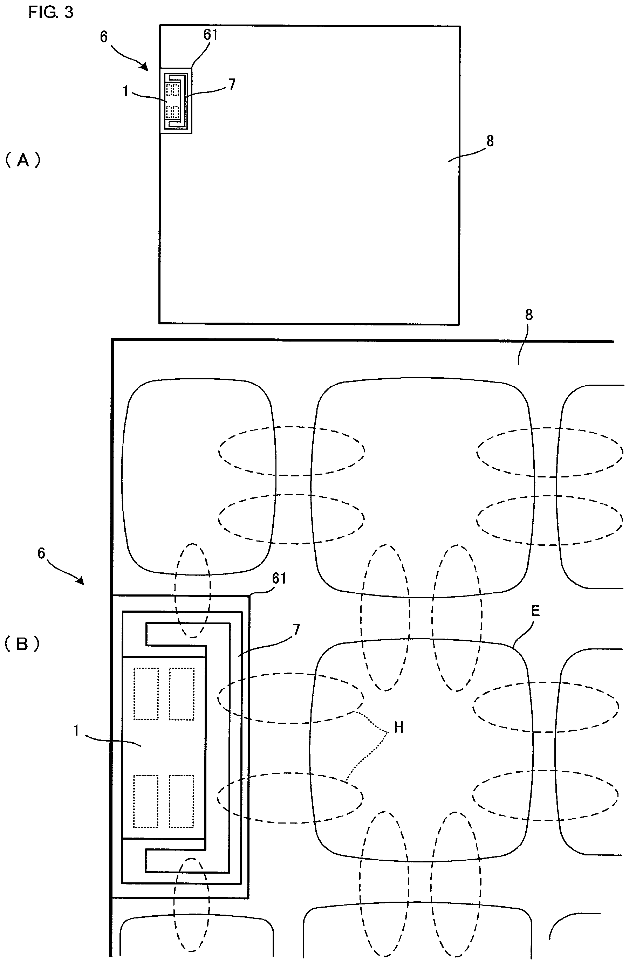

FIG. 3 is a view that shows the configuration of a wireless IC device and shows only a relevant portion of the article 70 shown in FIG. 2. In FIG. 3, a radiation electrode 8 corresponds to an aluminum-deposited layer of the aluminum-deposited laminated film of the article package 60 shown in FIG. 2. The cutout portion (electrode non-formation portion) 61 of the radiation electrode 8 forms a loop electrode 7 inside, and the electromagnetic coupling module 1 is mounted at the cutout portion 61 so as to be coupled to the loop electrode 7. The loop electrode 7 is patterned when aluminum deposition of the aluminum-deposited laminated film is performed. Alternatively, a conductive pattern may be formed by printing in a process different from the process of aluminum deposition.

FIG. 3(B) schematically shows an example of a distribution of electromagnetic field that is generated in the radiation electrode 8 when the loop electrode 7 is applied as a transmission auxiliary radiator. In the drawing, the broken line represents the loop of a magnetic field H, and the solid line represents the loop of an electric field E. The loop electrode 7 is applied as a magnetic field transmission auxiliary radiator. The magnetic field H generated by the loop electrode 7 perpendicularly intersects with the radiation electrode 8 to induce the electric field E. The electric field loop induces a magnetic field loop, and the chain of that action extends a distribution of electromagnetic field.

The above example is described using the loop electrode 7 as a transmission auxiliary radiator. When the loop electrode 7 is applied as a reception auxiliary radiator as well, a similar action may be attained to obtain a high gain.

In this way, when the article includes a conductive portion having a predetermined area and the conductive portion acts as a radiator, and when a large number of the articles are overlapped, chain induction of the electric field and magnetic field propagates among articles. Thus, even when a large number of articles are overlapped (if anything, overlapped), the wireless IC device operates to attain a high gain. For example, in a state where the antenna of a reader/writer is brought close to a portion of a pile of packed potato chips, IDs of all of the pile of packed potato chips may be read.

Note that the electromagnetic coupling module 1 shown in FIG. 3 includes a wireless IC chip, which will be described later, and a power supply circuit substrate that is connected to the wireless IC chip and that is coupled to an external circuit (in this example, the loop electrode 7, and the radiation electrode 8 via the loop electrode 7). The wireless IC chip and the power supply circuit substrate may be connected electrically or may be coupled electromagnetically. When they are coupled electromagnetically, a capacity is formed between connection electrodes of them with a dielectric thin film, or the like. By capacitively coupling the wireless IC chip and the power supply circuit substrate, it is possible to prevent the wireless IC chip from being broken due to static electricity.

In addition, when the power supply circuit substrate is used, two electrodes of the power supply circuit substrate are coupled electromagnetically to both ends of the loop electrode 7. In addition, the electromagnetic coupling module 1 may be replaced with a single piece of wireless IC chip. In this case, two electrodes of the wireless IC chip may be directly connected to both ends of the loop electrode 7. In any cases, because the loop electrode 7 is separated from the radiation electrode 8 in terms of direct current, the wireless IC device advantageously has a resistance against static electricity.

In addition, the loop electrode 7 may have any shape as long as the loop electrode 7 is arranged so as to couple input and output terminals of the electromagnetic coupling module 1.

### First Embodiment

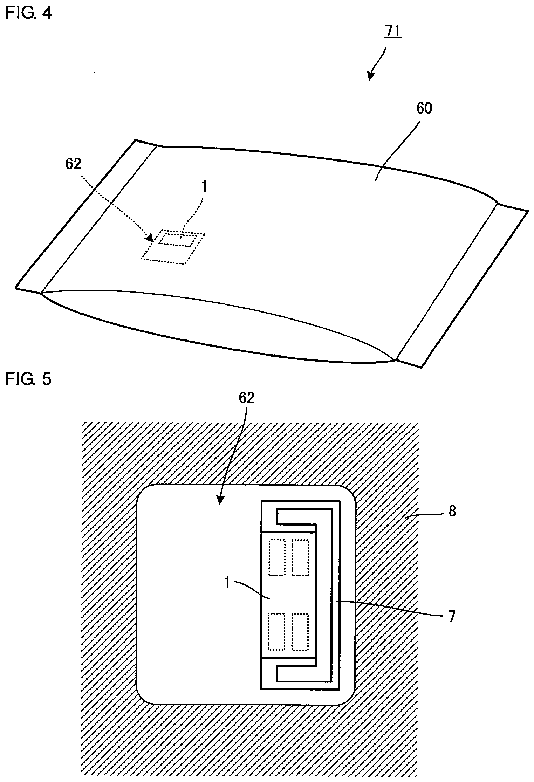

FIG. 4 is an external perspective view that shows the configuration of a wireless IC device according to a first embodiment and the configuration of an article provided with the wireless IC device. The article 71 is, for example, a packed snack. An article package 60 is a package that is formed so that an aluminum-deposited laminated film is formed into a bag-like shape.

In the example shown in FIG. 2, the electromagnetic coupling module is arranged at an edge portion of the article package, whereas in an example shown in FIG. 4, the electromagnetic coupling module 1 is provided at an inner side of the article package 60, away from the edge portion of the article package 60. The article package 60 is formed of an aluminum-deposited laminated film. Portion of the article package 60, at which aluminum is not deposited, is formed as a non-conductive portion 62. The electromagnetic coupling module 1 is arranged inside the non-conductive portion 62 and at an end of the non-conductive portion 62.

FIG. 5 is a view that shows a portion at which the electromagnetic coupling module 1 shown in FIG. 4 is mounted. In FIG. 5, the configuration of the loop electrode 7 and electromagnetic coupling module 1 is similar to that shown in FIG. 3 in the first example. The radiation electrode 8 corresponds to the aluminum-deposited layer of the aluminum-deposited laminated film of the article package 60. The loop electrode 7 and the electromagnetic coupling module 1 are arranged inside the non-conductive portion 62 so that the loop electrode 7 is located adjacent to three sides of the radiation electrode 8.

With the above configuration, the loop electrode 7 operates as a magnetic field transmission auxiliary radiator. The loop electrode 7 is coupled to the radiation electrode 8 and, owing to the action similar to that shown in FIG. 3, the radiation electrode 8 operates as a radiator of an antenna.

Note that when the area of the non-conductive portion 62 is set to be equal to the area occupied by the loop electrode 7 and the electromagnetic coupling module 1 and then the loop electrode 7 and the electromagnetic coupling module 1 are arranged inside the non-conductive portion 62, the magnetic field of the loop electrode 7 is coupled to the radiation electrode 8 at four sides and, therefore, electromagnetic field induced by the radiation electrode 8 is cancelled to reduce a gain. Thus, it is important that the area of the non-conductive portion 62 is sufficiently larger than the area occupied by the loop electrode 7 and the electromagnetic coupling module 1, and the loop electrode 7 is located adjacent to the radiation electrode 8 at one side, two sides, or three sides.

### Second Example

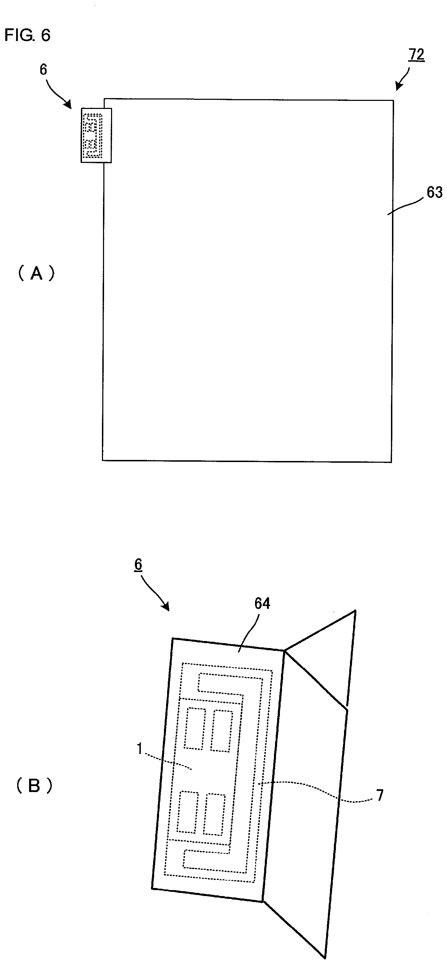

FIG. 6(B) shows the configuration of a main portion of a wireless IC device according to a second example. FIG. 6(A) is an external view of an article provided with the wireless IC device. In FIG. 6(A), the article 72 is such that a main portion 6 of the wireless IC device is provided on the metal plane body 63. The metal plane body 63 is a plate-like or sheet-like article that includes a metal layer inside or a metal plate itself.

The main portion 6 of the wireless IC device has a so-called tuck index shape as a whole as shown in FIG. 6(B) and has an adhesive layer on the inner face of an insulative sheet 64. The loop electrode 7 and the electromagnetic coupling module 1 are sandwiched by the insulative sheet 64. The configuration of the loop electrode 7 and electromagnetic coupling module 1 is similar to that shown in FIG. 3.

Then, the loop electrode 7 is attached so as to be located adjacent to an edge of the metal plane body 63 shown in FIG. 6A, that is, so as to just adhere a tuck index to the edge.

Even when no cutout is provided at an edge portion of the conductive portion as described above, by bringing the loop electrode 7 of the main portion 6 of the wireless IC device close to the edge portion of the metal plane body 63, the loop electrode 7 and the metal plane body 63 (conductive portion that operates as a radiator) are coupled to each other. Thus, the metal plane body 63 operates as a radiator of an antenna.

### Third Example

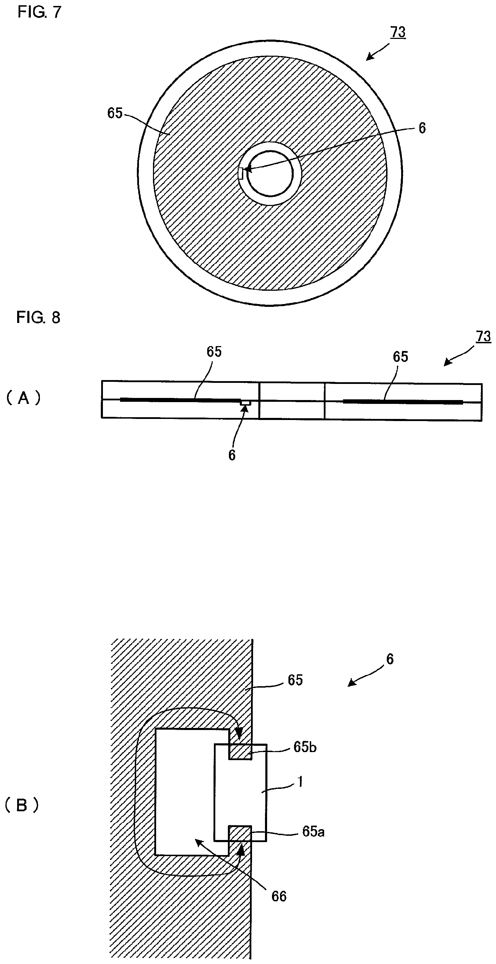

A wireless IC device according to a third example will be described with reference to FIG. 7 and FIG. 8. The wireless IC device according to the third example is applied to a recording medium having a metal film, such as a DVD.

FIG. 7 is a plan view of a DVD disk. FIG. 8(A) is a center cross-sectional view that is taken along the line passing the main portion 6 of the wireless IC device, and FIG. 8(B) is a partially enlarged plan view of the main portion 6 of the wireless IC device. However, the cross-sectional view of FIG. 8(A) is exaggerated in size in the thickness direction.

As shown in FIG. 7 and FIG. 8(A), the DVD disc 73 is formed by adhering two disc-shaped discs, one of the disc has a metal film 65 formed thereon, and the main portion 6 of the wireless IC device is provided at portion of the inner peripheral edge of the metal film 65.

As shown in FIG. 8(B), a C-shaped cutout portion 66 is formed at portion of the inner peripheral edge of the metal film 65. The cutout portion 66 is not a cutout of the disc but a cutout portion as a pattern of the metal film. The electromagnetic coupling module 1 is arranged so that two terminals of the electromagnetic coupling module 1, formed by the C-shaped cutout portion, face two protruding ends facing each other. The inner peripheral end (portion indicated by the arrow in the drawing) of the C-shaped cutout portion is operated as a loop electrode.

### Second Embodiment

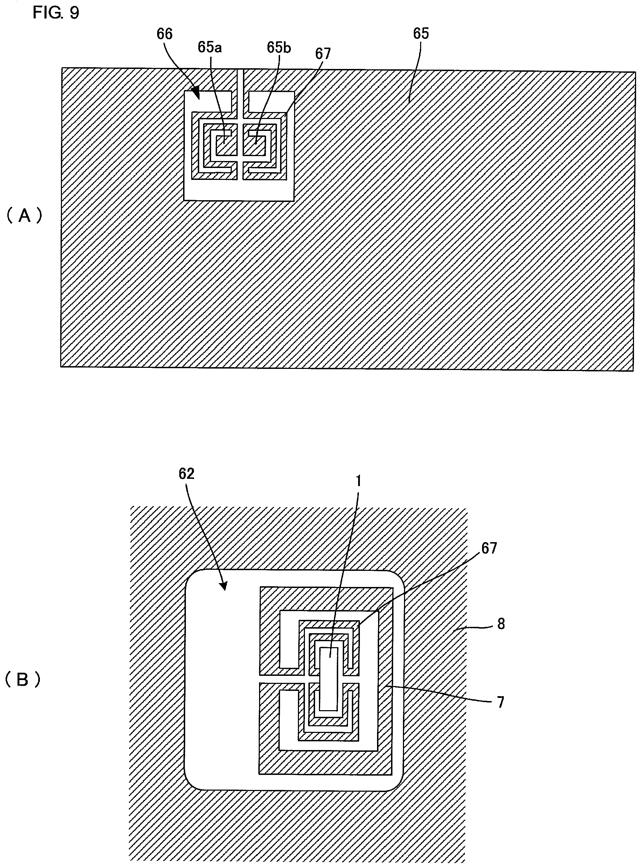

FIG. 9 is a view that shows the configuration of two wireless IC devices according to a second embodiment. The second embodiment provides a matching circuit between a mounding portion of a high-frequency device and a loop electrode. The matching circuit establishes direct electrical connection between the high-frequency device and the loop electrode.

In FIG. 9(A), the metal film 65 is formed into a sheet material or a plate material, and operates as a radiator. By forming a cutout portion 66 at portion of the metal film 65, the portion extending along the inner peripheral edge of the cutout portion 66 operates as a loop electrode.

The matching circuit 67 formed of a meander electrode and metal film portions 65a and 65b, which are mounting portions for the high-frequency device (electromagnetic coupling module or wireless IC chip), are formed inside the cutout portion 66.

By providing the matching circuit 67 in this way, the wireless IC chip may be directly mounted at the metal film portions 65a and 65b. Note that when the wireless IC chip is directly mounted on the loop electrode, the loop electrode including the matching circuit 67 substantially determines operating frequency of the wireless IC device.

In FIG. 9(B), the radiation electrode 8 has the non-conductive portion 62 formed therein, and the loop electrode 7, matching circuit 67 and electromagnetic coupling module 1 are arranged inside the non-conductive portion 62 so that the loop electrode 7 is located adjacent to three sides of the radiation electrode 8. The configuration of the matching circuit 67 and mounting portion of the electromagnetic coupling module 1 is similar to the example of FIG. 9(A).

With the above configuration, the loop electrode 7 operates as a magnetic field radiator. The loop electrode 7 is coupled to the radiation electrode 8 and, owing to the action similar to that shown in FIG. 3, the radiation electrode 8 operates as a radiator.

Note that the metal film 65 of FIG. 9(A) or the radiation electrode 8 of FIG. 9(B) may be, for example, a solid electrode that is formed on the circuit substrate inside a cellular phone terminal.

### Third Embodiment

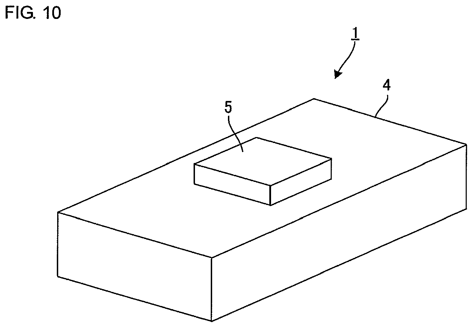

FIG. 10 is an external perspective view of an electromagnetic coupling module 1 used for a wireless IC device according to a third embodiment. The electromagnetic coupling module 1 may be applied to the wireless IC devices in the other embodiments. The electromagnetic coupling module 1 is formed of a wireless IC chip 5 and a power supply circuit substrate 4. The power supply circuit substrate 4 matches an impedance between the metal film 65, which operates as a radiator, and the wireless IC chip 5, and also operates as a resonant circuit.

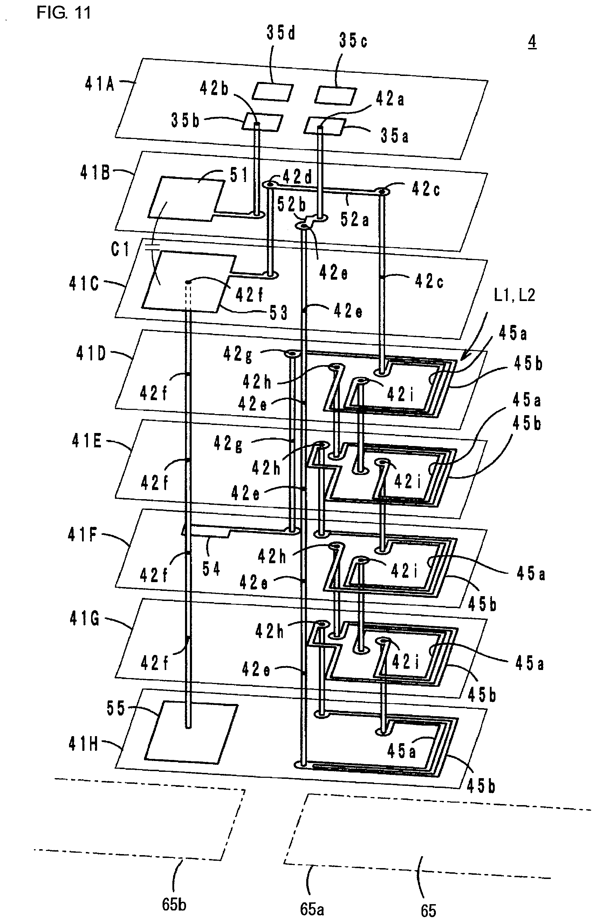

FIG. 11 is an exploded view that shows the configuration of the inside of the power supply circuit substrate 4. The power supply circuit substrate 4 is formed of a multilayer substrate formed by laminating a plurality of dielectric layers in which electrode patterns are respectively formed. Wireless IC chip mounting lands 35a to 35d are formed on the uppermost dielectric layer 41A. A capacitor electrode 51 that is electrically connected to the wireless IC chip mounting land 35b is formed on the dielectric layer 41B. A capacitor electrode 53 is formed on the dielectric layer 41C and forms a capacitor C1 with the capacitor electrode 51. Inductor electrodes 45a and 45b are formed on each of the dielectric layers 41D to 41H. The inductor electrodes 45a and 45b formed over these plurality of layers form a spiral shape as a whole, and constitute inductors L1 and L2 that are strongly inductively coupled to each other. In addition, a capacitor electrode 54 is formed on the dielectric layer 41F and is electrically connected to the inductor L1. The capacitor electrode 54 is placed between the two capacitor electrodes 53 and 55 to form a capacitor. In addition, a capacitor electrode 55 is formed on the dielectric layer 41H and is electrically connected to the capacitor electrode 53. Via holes 42a to 42i are formed to electrically connect between the electrodes of the dielectric layers.

The capacitor electrode 55 faces an end 65b of the metal film, which is formed at the cutout portion of the metal film 65 shown in FIG. 8. A capacitor between the end 65b and the capacitor electrode 55. In addition, the inductor electrodes 45a and 45b are electromagnetically coupled to the metal film portion 65a facing thereto.

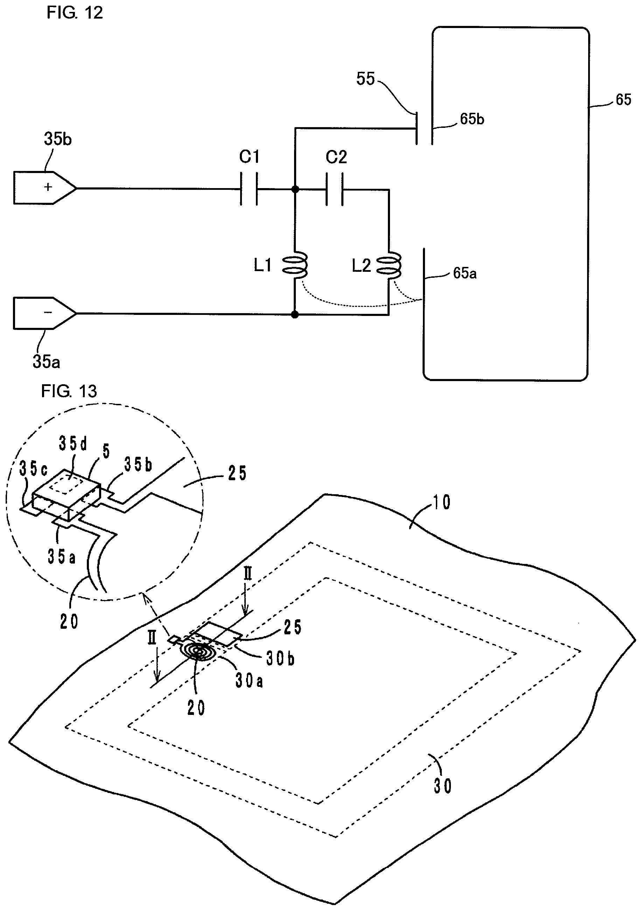

FIG. 12 is an equivalent circuit diagram that includes the power supply circuit substrate and the cutout portion of the metal film shown in FIG. 11. In FIG. 12, the capacitor C1 is a capacitor generated between the capacitor electrodes 51 and 53 shown in FIG. 11, the capacitor C2 is a capacitor generated between the capacitor electrode 54 and the capacitor electrodes 53 and 55 shown in FIG. 11, and the inductors L1 and L2 are formed by the inductor electrodes 45a and 45b shown in FIG. 11. The metal film 65 shown in FIG. 12 is a loop that extends along the inner peripheral edge of the cutout portion 66 shown in FIG. 8. The capacitor electrode 55 is capacitively coupled to one end 65b, and the other end 65a is electromagnetically coupled to the inductors L1 and L2. Thus, the loop that extends along the inner peripheral edge of the cutout portion 66 operates as a loop electrode.

Note that in the second embodiment, the loop that extends along the inner peripheral end of the cutout portion of the metal film is operated as the loop electrode; instead, as shown in FIG. 3, and the like, it is applicable that a loop electrode is formed inside the cutout portion, and the electromagnetic coupling module 1 that includes the wireless IC chip 5 and the power supply circuit substrate 4 are mounted to the loop electrode. In this case, the loop electrode and the metal film 65 are coupled, and the metal film 65 operates as a radiator.

In the power supply circuit substrate 4, a resonant frequency is determined in a resonant circuit formed of the inductance elements L1 and L2 and its stray capacitance. The frequency of a signal radiated from the radiation electrode is substantially determined on the basis of a self-resonant frequency of the resonant circuit.

The electromagnetic coupling module 1, which is formed so that the wireless IC chip 5 is mounted on the power supply circuit substrate 4, receives a high-frequency signal (for example, UHF frequency band) radiated from a reader/writer (not shown) through the radiation electrode, resonates the resonant circuit in the power supply circuit substrate 4 and then supplies only a reception signal of a predetermined frequency band to the wireless IC chip 5. On the other hand, the electromagnetic coupling module 1 extracts a predetermined amount of energy from the reception signal, matches information stored in the wireless IC chip 5 with a predetermined frequency in the resonant circuit using the extracted energy as a driving source, and then transmits the information to the radiation electrode. The information is further transmitted from the radiation electrode to the reader/writer.

In this way, by providing the resonant circuit in the power supply circuit substrate, selectivity of frequency increases. Thus, the operating frequency of the wireless IC device may be mostly determined using the self-resonant frequency. In accordance with the above, it is possible to transfer (exchange) energy of a signal of a frequency used in an RFID system with high efficiency. In addition, it is possible to set an optimum resonant frequency in consideration of the shape and size of a radiator. This may improve the radiation characteristic of the wireless IC device.

Note that the wireless IC chip and the mounting lands of the power supply circuit substrate may be electrically connected or may be capacitively coupled through insulation.

In addition, by providing the matching circuit in the power supply circuit substrate, it is possible to transfer (exchange) energy of a signal of a frequency used in an RFID system with high efficiency.

### Fourth Embodiment

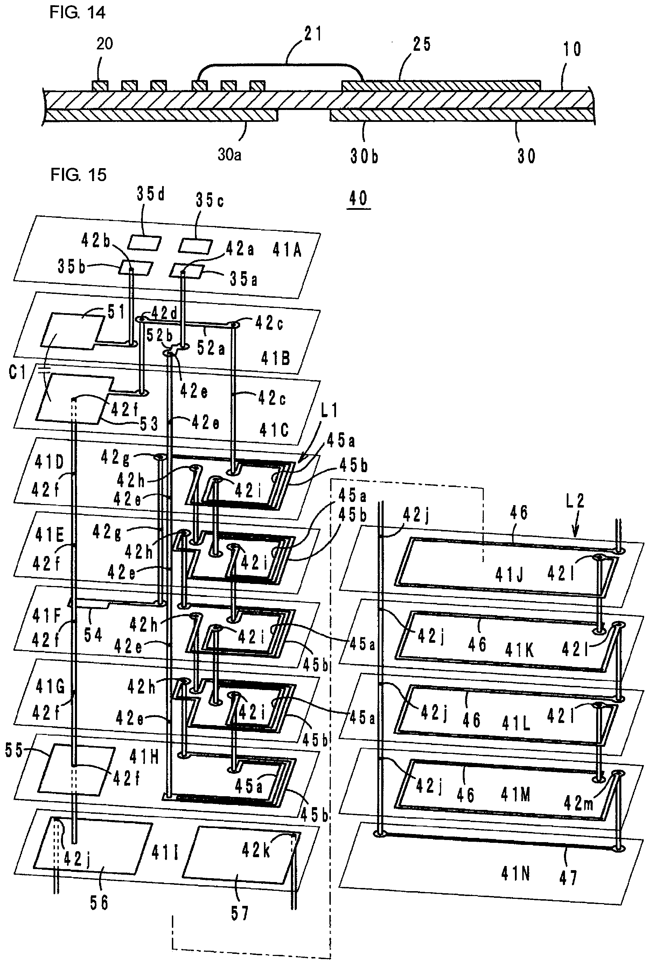

FIG. 13 is a perspective view that shows the configuration of a main portion of a wireless IC device according to a second embodiment. FIG. 14 is an enlarged partially cross-sectional view of FIG. 13.

In FIG. 13, a base material 10 is the base material of an article for which the wireless IC device is provided and is, for example, an aluminum-deposited laminated film. On the aluminum-deposited layer of the base material 10, a loop electrode 30 that is in a predetermined portion of the non-conductive portion described in the first embodiment. An inductor electrode 20 and a capacitor electrode 25 are formed above the open two ends 30a and 30b via an insulating layer. The inductor electrode 20 has a spiral shape and, as will be described later, the inside end is connected to the capacitor electrode 25.

The wireless IC chip 5 is mounted at the ends of the inductor electrode 20 and capacitor electrode 25, as shown in the enlarged view in the drawing. That is, the wireless IC chip mounting land 35a is formed at the end of the inductor electrode 20 and the wireless IC chip mounting land 35b is formed at the end of the capacitor electrode 25, and, furthermore, the mounting lands 35c and 35d are formed. Then, the wireless IC chip 5 is mounted.

FIG. 14 is a cross-sectional view that is taken along the line II-II in FIG. 13. As shown in FIG. 14, the inductor electrode 20 faces the end 30a of the loop electrode. A wire 21 connects the inside end of the inductor electrode 20 shown in FIG. 13 with the capacitor electrode 25.

In this way, capacitors and inductors for matching impedance and adjusting resonant frequency may be formed on the side of the base material 10 of an article, and the wireless IC chip 5 may be directly mounted.

### Fifth Embodiment

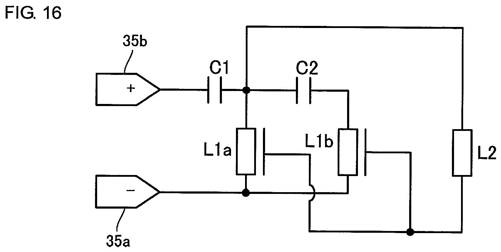

FIG. 15 is an exploded perspective view of a power supply circuit substrate 40 of a wireless IC device according to a third embodiment. In addition, FIG. 16 is an equivalent circuit diagram thereof.

The power supply circuit substrate 40 is formed of a multilayer substrate formed by laminating a plurality of dielectric layers in which electrode patterns are respectively formed. Wireless IC chip mounting lands 35a to 35d are formed on the uppermost dielectric layer 41A. A capacitor electrode 51 that is electrically connected to the wireless IC chip mounting land 35b is formed on the dielectric layer 41B. A capacitor electrode 53 is formed on the dielectric layer 41C and forms a capacitor C1 with the capacitor electrode 51. Inductor electrodes 45a and 45b are formed on each of the dielectric layers 41D to 41H. The inductor electrodes 45a and 45b formed over these plurality of layers constitute, as a whole, an inductor L1 that has a spiral shape. In addition, a capacitor electrode 54 is formed on the dielectric layer 41F and is electrically connected to the inductor L1. The capacitor electrode 54 is placed between the two capacitor electrodes 53 and 55 (or 56) to form a capacitor. In addition, a capacitor electrode 55 is formed on the dielectric layer 41H and is electrically connected to the capacitor electrode 53.

Capacitor electrodes 56 and 57 are formed on a dielectric layer 41I. The capacitor electrode 56 is electrically connected to the capacitor electrodes 53 and 55. In addition, the capacitor electrode 57 is electromagnetically coupled to the inductor electrodes 45a and 45b.

Inductor electrodes 46 and 47 are formed on each of dielectric layers 41J to 41N. The inductor electrodes 46 and 47 form a loop electrode L2 that is wound multiple times. Via holes 42a to 42m are formed to electrically connect between the electrodes of the dielectric layers.

That is, the power supply circuit substrate 40 is just formed so that the loop electrode is included in the power supply circuit substrate 4 shown in FIG. 11. Thus, by installing the electromagnetic coupling module, which is formed by mounting the wireless IC chip on the power supply circuit substrate 40, to an article, the wireless IC device may be formed, and it is not necessary to form a loop electrode on the article side.

In FIG. 16, the capacitor C1 is a capacitor generated between the capacitor electrodes 51 and 53 shown in FIG. 15, the capacitor C2 is a capacitor generated between the capacitor electrode 54 and the capacitor electrodes 53 and 55 shown in FIG. 15, the inductors L1a and L1b are respectively formed by the inductor electrodes 45a and 45b shown in FIG. 15, and the inductor L2 is formed by the inductor electrodes 46 and 47 shown in FIG. 15.

### Sixth Embodiment

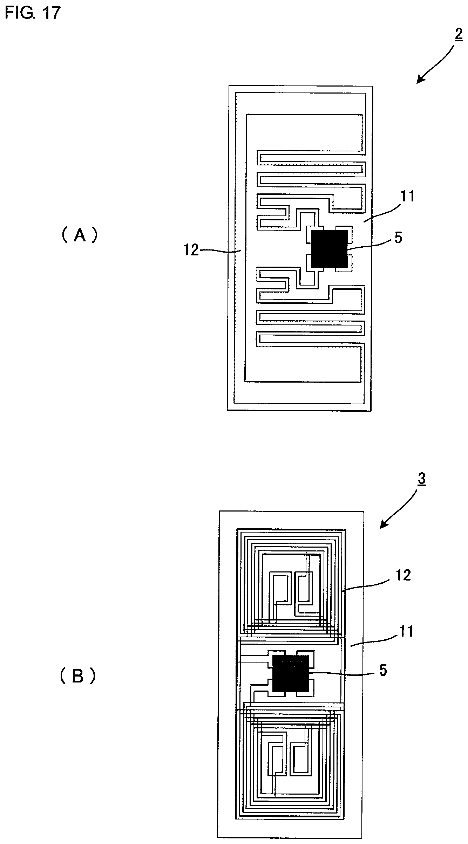

FIG. 17 are plan views of an electromagnetic coupling module used for a wireless IC device according to a fourth embodiment. In the example of FIG. 17(A), a loop electrode 12 and wireless IC chip mounting lands are formed on the substrate 11 by an electrode pattern, and the wireless IC chip 5 is mounted.

In the example shown in FIG. 15, the capacitors and inductors for matching impedance and adjusting resonant frequency are formed on the power supply circuit substrate together with the loop electrode, whereas in the example shown in FIG. 17, the loop electrode and the wireless IC chip basically integrated.

In the example of FIG. 17(B), spiral electrode patterns are respectively formed on the top and bottom faces of the substrate 11, capacitor electrode that places the substrate 11 in between are arranged at the center of each spiral electrode pattern, and then the line on the top face and the line on the bottom face are connected via the capacitors. That is, the line length and inductance are gained within a limited area by utilizing both faces of the substrate 11 to thereby form the loop electrode 12.

Two electromagnetic coupling modules 2 and 3 shown in FIG. 17 each are arranged adjacent to a metal film of an article, which operates as a radiator, or a metal plate so that the radiation electrode is capacitively coupled to the loop electrode 12. By so doing, without forming any specific circuit on the article side, as in the case of the first embodiment, it is possible to utilize the metal film of the article or the metal plate as a radiator of an antenna.

### Seventh Embodiment

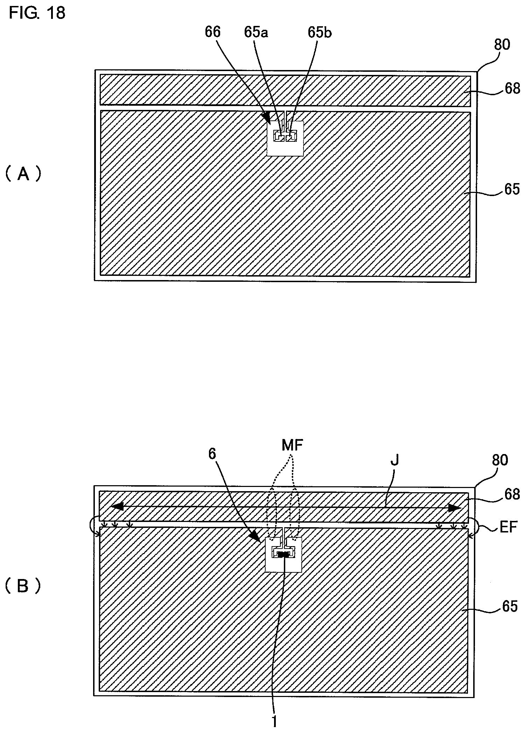

FIG. 18 are views that show the configuration of a wireless IC device according to a seventh embodiment. In the first to sixth embodiments, the article package 60, the metal plane body 63, the metal film 65, and the like, in which a conductive plane extends in a planar manner, are operated as a radiator, whereas in the seventh embodiment, a resonant conductor that is insulated from a planar conductive plane and that operates as a resonator is provided.

FIG. 18(A) is a plan view of a conductive pattern on a printed wiring substrate when an RFID tag is formed on the printed wiring substrate. In addition, FIG. 18(B) is a plan view of a wireless IC device that operates as an RFID tag, which is formed so that the electromagnetic coupling module 1 formed of a wireless IC chip and a power supply circuit substrate is mounted on the printed wiring substrate.

A metal film 65, which is used as a ground electrode of another circuit, is formed on the upper face of the printed wiring substrate 80. The metal film 65 partially forms a cutout portion (metal film non-formation portion) 66, and the metal film portions 65a and 65b, which form a mounting portion for a high-frequency device (electromagnetic coupling module or wireless IC chip), are formed inside the cutout portion 66.

As shown in FIG. 18(B), by mounting the high-frequency device 1 on the metal film portions 65a and 65b, the portion that extends along the inner peripheral edge of the cutout portion 66 operates as a loop electrode. The mounting area of the high-frequency device 1 forms a main portion 6 of the wireless IC device.

A resonant conductor 68 that is coupled to the high-frequency device 1 is formed on the upper face of the printed wiring substrate 80. The resonant conductor 68 has determined dimensions (particularly, length) so that the resonant frequency is a frequency used in an RFID tag or a frequency therearound. For example, when a glass epoxy substrate is used and the operating frequency is a UHF band, the length of the resonant conductor 68 just needs to be several tens centimeters so as to operate as a both-end-open half-wavelength resonator.

The resonant conductor 68 is arranged so that the center is located adjacent to the loop electrode of the main portion 6 of the wireless IC device, so as to be coupled to the high-frequency device 1. In addition, in this example, it is arranged along one side of the metal film 65 in an insulated manner.

In FIG. 18(B), the arrow J shown in the resonant conductor 68 typically represents an electric current path, the arrow EF typically represents an electric field distribution, and the arrow MF typically represents a magnetic field distribution. In this way, the magnitude of an electric current that flows through the resonant conductor 68 becomes maximum around the center. Thus, the magnetic field generated at the resonant conductor 68 becomes maximum around the center, and the resonant conductor 68 is strongly magnetically coupled to the portion of the loop electrode, extending along the inner peripheral edge of the cutout portion 66.

When the resonant conductor 68 is resonating around the operating frequency of the RFID tag, an electric current that flows through the resonant conductor 68 and a voltage generated across both ends of the resonant conductor 68 increases. Owing to the magnetic field and electric field generated by these electric current and voltage as well, the resonant conductor 68 is coupled to the metal film 65.

The peak of a voltage of a standing wave generated at the resonant conductor 68 is formed at an end of the resonant conductor 68. In this example, because the length of the resonant conductor 68 is substantially equal to one end of the metal film 65 that operates as a radiator, the resonant conductor 68 is strongly coupled to the metal film 65. Thus, a high gain is obtained. Through the actions described above, it is possible to obtain an excellent characteristic as an RFID tag.

When no resonant conductor 68 is present, resonance just needs to be performed in the metal film 65 at the operating frequency of an RFID tag; however, due to restriction on size of the metal film 65 and depending on components mounted on the printed wiring substrate, resonant frequency shifts. According to the embodiment, because the metal film 65 is separated from the resonant conductor 68, the resonant conductor 68 may be designed as a single unit, and a shift in resonant frequency due to mounted components also does not occur.

Note that in the seventh embodiment, only the metal film, as a ground electrode, and the resonant conductor are described as an electrode pattern formed on the printed wiring substrate; however, an electrode pattern is appropriately determined on the basis of a circuit to be formed and an electronic component to be mounted. This also applies to other embodiments described below.

When an RFID tag is formed on the above constructed printed wiring substrate, and information such as manufacturing process history is written to the RFID tag, it is possible to manage, for example, a process of mounting components to a printed wiring substrate. For example, when malfunction of an electronic component is detected in lot unit, it is possible to take measures only by withdrawing a small number of electronic devices that have the electronic component included in that lot. In addition, it has an advantageous effect such that post-sales support and maintenance at the time when the product is in operation in the market may be quickly performed, and a process for recycling as a resource after disposal will be simple.

In addition, after process management is ended, portion of the printed wiring substrate, forming the resonant conductor 68, may be torn off. By so doing, the size of the printed wiring substrate may be small, and it is possible to reduce the size of a product without losing the function of an RFID tag. Because the resonant conductor 68 is present at the time of process management, data may be read even when the output level of a reader/writer is low. By lowering the output of an RF signal, it is possible to suppress malfunction of a control device, a characteristic measurement device, and the like. Furthermore, after the resonant conductor 68 is torn off, the metal film 65 also operates as a radiator. Thus, communication is still possible although a communicable distance with a reader/writer is reduced.

When the printed wiring substrate is conveyed in a general manufacturing process, rails may be arranged on both sides of the printed wiring substrate and then the printed wiring substrate may be conveyed on the rails. In order to prevent breakage of the portions that contact the rails, the printed wiring substrate has a margin portion that will be finally torn off. If the resonant conductor 68 is formed at the margin portion, wasted space of the printed wiring substrate is removed.

Note that the metal film 65, which is a ground electrode, may be formed in a plurality of layers of the printed wiring substrate. In this case, the region of the cutout portion 66 in each layer is formed as a metal film non-formation portion so that a magnetic flux passes therethrough.

According to the embodiment, a radiation gain at the operating frequency of an RFID tag increases, and an excellent characteristic of an RFID is obtained. In addition, because the resonant frequency of the resonant conductor is not influenced by components mounted on the printed wiring substrate, design is easy.

### Eighth Embodiment

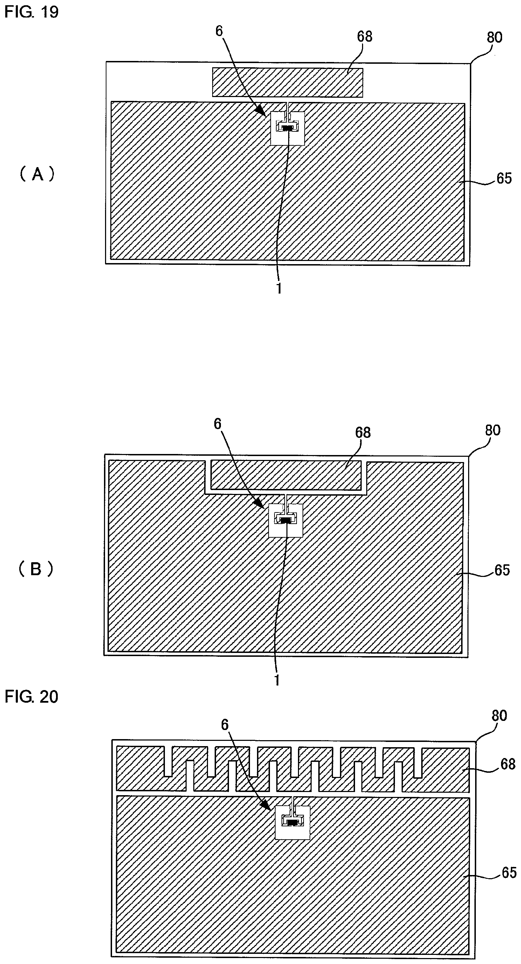

FIG. 19 to FIG. 21 are views that show some configurations of a wireless IC device according to an eighth embodiment. Any drawings are plan views of a wireless IC device such that an RFID tag is formed on a printed wiring substrate.

In the examples of FIGs. 19(A) and (B), the metal film 65, which is used as a ground electrode for another circuit, is formed on the upper face of the printed wiring substrate 80. The metal film 65 partially forms a cutout portion (metal film non-formation portion), and a high-frequency device (electromagnetic coupling module or wireless IC chip) is mounted inside the cutout portion, so that the main portion 6 of the wireless IC device similar to that shown in FIG. 18 is formed.

The configuration differs from the configuration shown in FIG. 18 in that the length of the resonant conductor 68 is smaller than one side of the metal film 65 as a radiator. In the example of FIG. 19(A), the resonant conductor 68 is formed along one side of the metal film 65. In the example of FIG. 19(B), the resonant conductor 68 is formed at a position that is separated from an area in which the metal film 65 is formed.

Even with the above relationship, when the printed wiring substrate 80 and the metal film 65 are large in area (long) and a resonance frequency owing to the metal film 65 is low, the resonant frequency of the resonant conductor 68 may be set to around the operating frequency of an RFID. Thus, a high gain is obtained.

In the example of FIG. 20, the resonant conductor 68 is formed in a meander line shape and the entire of the resonant conductor 68 is arranged along one side of the metal film 65.

According to the above configuration, because the resonator length may be increased even when the profile of the resonant conductor 68 is short, a high gain may be obtained when it is resonated at a relatively low frequency.

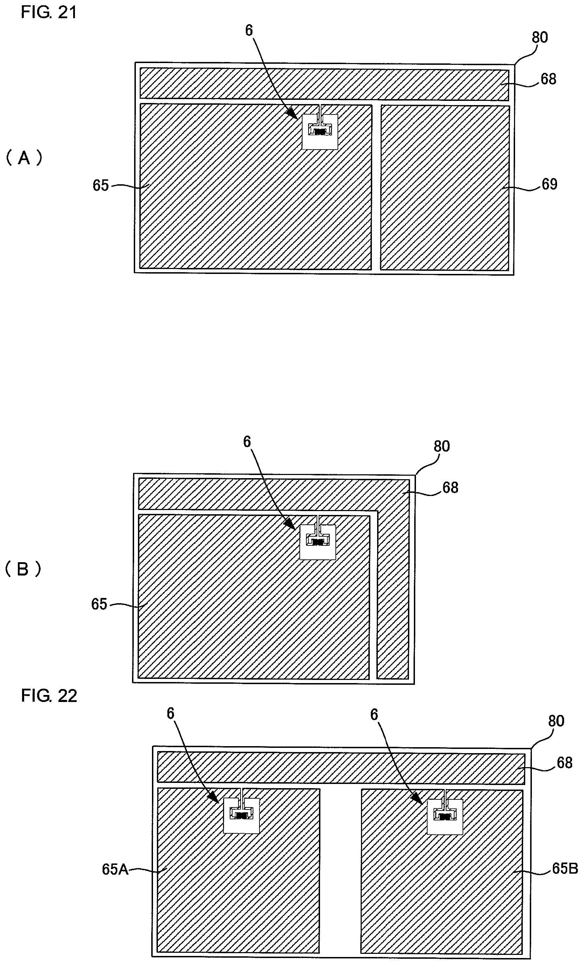

In the example of FIG. 21, the resonant conductor 68 is longer than one side of the metal film 65 that is operated as a radiator. In addition, a main portion 6 of the wireless IC device is formed at a position shifted from the center of one side of the metal film 65 that is operated as a radiator. In this case as well, as shown in FIGs. 21(A) and (B), the center of the resonant conductor 68 just needs to be arranged adjacent to the loop electrode of the main portion 6 of the wireless IC device.

In the example shown in FIG. 21(A), a metal film 69 for forming another ground electrode or another circuit is formed in a margin at a position adjacent to the metal film 65. In addition, in the example of FIG. 21(B), the resonant conductor 68 is formed along two sides of the metal film 65.

In this way, even when the pattern of the metal film 65 that operates as a radiator is small, a high gain is obtained by providing the resonant conductor 68 having a length that gives a necessary resonant frequency.

### Ninth Embodiment

FIG. 22 is a view that shows the configuration of a wireless IC device according to a ninth embodiment. In FIG. 22, the main portion 6 of the wireless IC device similar to that shown in FIG. 18 is formed in each of two metal films 65A and 65B on the upper face of a printed wiring substrate 80. Then, a resonant conductor 68 is formed so as to be coupled to both high-frequency devices provided at the main portions 6 of the two wireless IC devices. That is, one resonant conductor 68 is shared by two high-frequency devices.

For example, the printed wiring substrate 80 may form RFID tags having different frequency bands (for example, even in the same UHF band, a frequency of standards in accordance with a destination) by being finally torn off into the side at which a metal film 65A is formed and the side at which a metal film 65B is formed.

When the resonant conductor 68 is longer than one side of the metal film 65 that operates as a radiator, the resonant conductor 68 may be easily shared as a resonator for a plurality of high-frequency devices as described above. In addition, even when shared frequencies are different, the resonant frequency just needs to be set to a frequency approximate to the frequencies used in the plurality of RFID tags.

When the resonant conductor 68 is used only in the manufacturing process, it will be separated from the printed wiring substrate 80 later. Thus, the mother printed wiring substrate does not have a wasted space of an electrode pattern, so that it is possible to avoid an increase in cost due to formation of the resonant conductor 68.

### Tenth Embodiment

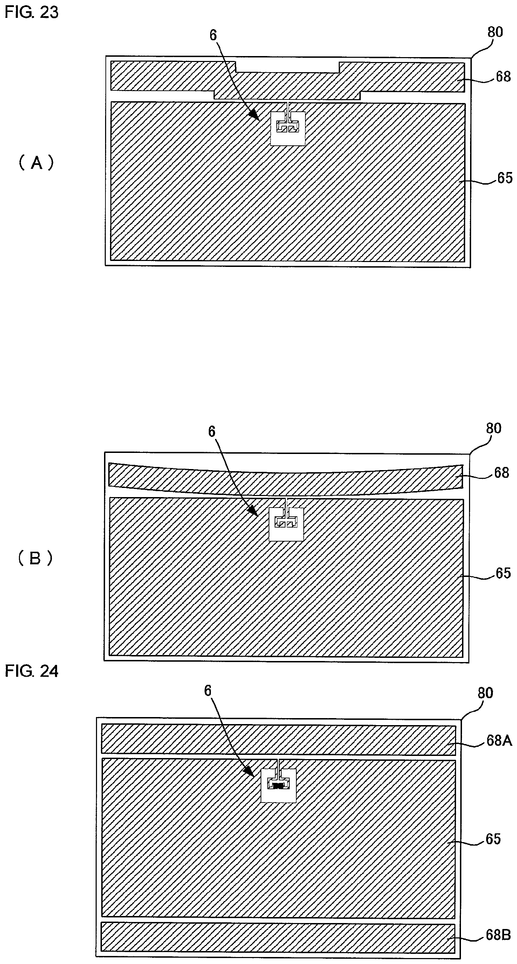

FIG. 23 is a view that shows some configurations of a wireless IC device according to a tenth embodiment. Any drawings are plan views of a wireless IC device such that an RFID tag is formed on a printed wiring substrate.

In the examples of FIGs. 23(A) and (B), the metal film 65, which is used as a ground electrode for another circuit, is formed on the upper face of the printed wiring substrate 80. A main portion 6 of the wireless IC device similar to that shown in FIG. 18 is formed at portion of the metal film 65.

The configuration differs from the configuration shown in FIG. 18 in that only a portion around the center of the resonant conductor 68 is arranged adjacent to the loop electrode of the main portion 6 of the wireless IC device. Depending on the relationship between the length of one side of the metal film 65 that operates as a radiator and the length of the resonant conductor 68, portions near both ends of the resonant conductor 68 may be formed in a shape so as to be located away from the metal film 65 as described above.

### Eleventh Embodiment

FIG. 24 is a plan view that shows the configuration of a wireless IC device according to an eleventh embodiment. The configuration differs from the configuration shown in FIG. 18 in that resonant conductors 68A and 68B are respectively arranged along two sides of the metal film 65 as a radiator.

One resonant conductor 68A, as in the case shown in FIG. 18, is strongly coupled to a high-frequency device provided at the main portion 6 of the wireless IC device. The other resonant conductor 68B is located adjacently along the metal film 65. Thus, the other resonant conductor 68B is coupled to the high-frequency device via an electromagnetic field distributed in the metal film 65. Both the resonant conductors 68A and 68B operate as a both-end-open half-wavelength resonator.

The plurality of resonant conductors 68 are not limited to that they are arranged along two opposite sides of the metal film 65; they may be arranged along sides of the metal film 65, which are perpendicular to each other.

### Twelfth Embodiment

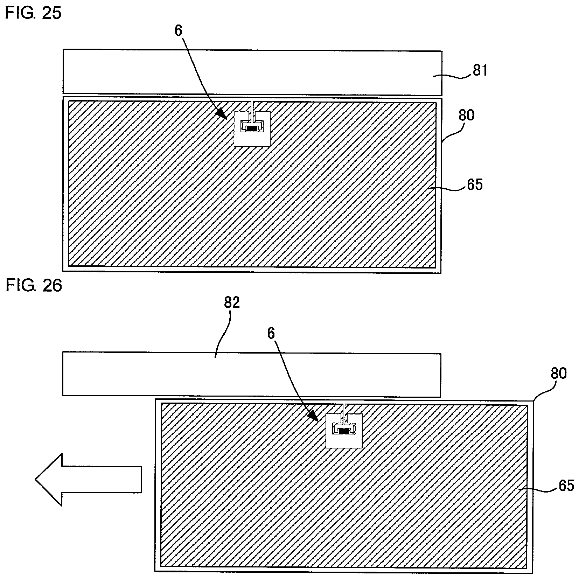

FIG. 25 is a plan view that shows the configuration of a wireless IC device according to a twelfth embodiment. In the seventh to eleventh embodiments, the resonant conductor is formed on the printed wiring substrate, whereas in the twelfth embodiment, a metal case of a device, on which the wireless IC device is mounted, or a mounting destination component 81, such as a mounting component, also serves as the resonant conductor.

With the above configuration, the metal case of the device, on which the wireless IC device is mounted, the mounting component, or the like, operates as a resonator. Thus, it is not necessary to form a resonant conductor on the printed wiring substrate. This can reduce the size of the printed wiring substrate 80 and, hence, the cost may be reduced.

### Thirteenth Embodiment

In the thirteenth embodiment, a resonant conductor is fixed, and at the time when a printed wiring substrate is conveyed along a process line, the printed wiring substrate communicates with a reader/writer.

FIG. 26 is a plan view that shows the configuration of a wireless IC device according to the thirteenth embodiment. In FIG. 26, a process line installed conductor 82 is arranged along the process line along which the printed wiring substrate 65 is conveyed. The reader/writer is arranged at a position relatively close to the process line installed conductor 82 (but not necessarily adjacent position).

A main portion 6 of a wireless IC device similar to that shown in FIG. 18 is formed on the metal film 65 of the printed wiring substrate 80.

When the printed wiring substrate 80 is conveyed along the process line and the main portion 6 of the wireless IC device is located adjacent to the process line installed conductor 82, the process line installed conductor 82 operates as a resonator that resonates at the frequency of an RFID tag. Thus, it is possible to communicate with the reader/writer with a high gain in that state.

According to the above configuration and communication method, because no resonant conductor is required on the printed wiring substrate, the area of a wirable portion increases. In addition, because it operates as an RFID tag only when the printed wiring substrate 80 is located close to the process line installed conductor 82, it is possible to communicate only with an RFID tag placed at a specific position. That is, it is possible to selectively communicate only with a desired RFID tag without communicating with an unintended ambient RFID tag.

### Fourteenth Embodiment

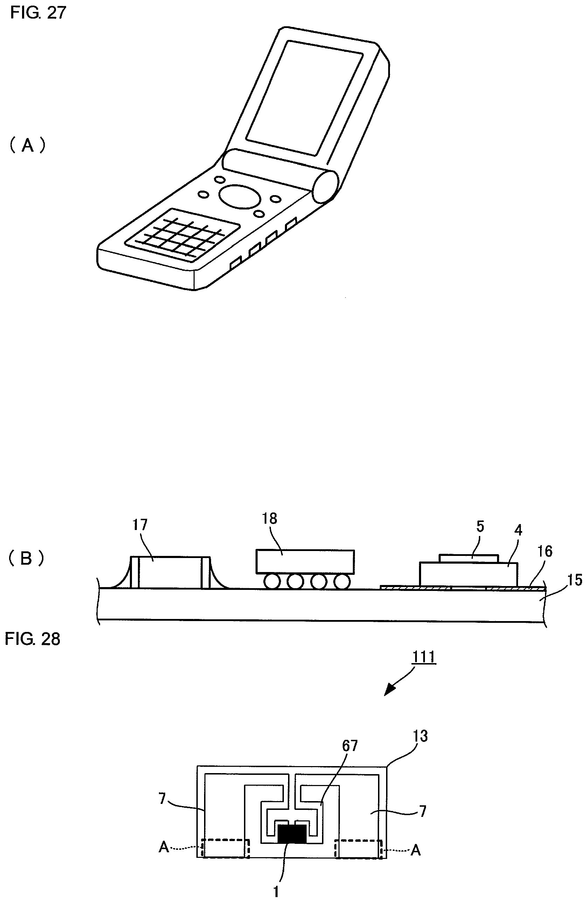

FIG. 27(A) is a perspective view of a cellular phone terminal provided with a wireless IC device, and FIG. 27(B) is a cross-sectional view of a main portion of an internal circuit substrate. The power supply circuit substrate 4, on which the wireless IC chip 5 is mounted, is installed on the circuit substrate 15 inside a cellular phone terminal, together with electronic components 17 and 18. An electrode pattern 16 that spreads in a predetermined area is formed on the upper face of the circuit substrate 15. The electrode pattern 16 is coupled to the wireless IC chip 5 via the power supply circuit substrate 4 to operate as a radiator.

In addition, as another example, a wireless IC device may be formed at a metal panel provided at the rear face of an internal component (for example, liquid crystal panel) of the cellular phone terminal shown in FIG. 27(A). That is, the metal panel may be operated as a radiator of an antenna by applying the wireless IC device shown in the first to fourth embodiments.

Note that it may be similarly applied to any articles having a conductive portion with a predetermined area, other than the above described embodiments. For example, it may also be applied to a medicine or snack packed with a composite film including aluminum foil, such as a press through package (PTP) package.

### Fifteenth Embodiment

In the example shown in FIG. 9(A), the metal film 65 that operates as a radiator is formed in a sheet material or a plate material, and the metal film 65 partially forms the cutout portion 66, so that the portion extending along the inner peripheral edge of the cutout portion 66 is operated as the loop electrode. When the above configuration is applied to the printed wiring substrate, a characteristic as an RFID tag fluctuates depending on a circuit formed on the printed wiring substrate. Thus, the degree of difficulty in designing of the printed wiring substrate increases. A fifteenth embodiment eliminates the above problem.

FIG. 28 is a plan view that shows the configuration of a component for a wireless IC device according to the fifteenth embodiment. A mounting portion, on which an electromagnetic coupling module 1 is mounted, a matching circuit 67, and a loop electrode 7, which is a liner electrode, are formed on a printed wiring substrate 13, such as a glass epoxy substrate. The ends of the loop electrode 7 are extended to an end of one side of the printed wiring substrate 13 as soldering electrode portions indicated by A. The electromagnetic coupling module 1 is mounted on the printed wiring substrate 13 to form a component 111 for a wireless IC device.

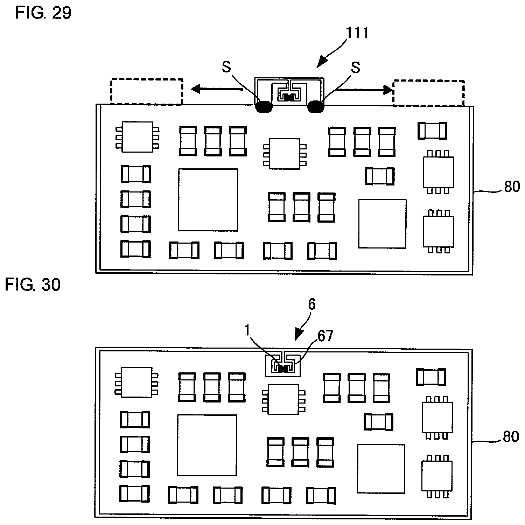

FIG. 29 is a plan view that shows a wireless IC device that uses the component for a wireless IC device according to a fourth example. As shown in FIG. 29, the component 111 for a wireless IC device is soldered to a position at which the loop electrode of the printed wiring substrate 80 will be formed. When a resist film is coated on the electrodes of the printed wiring substrate 80, the resist film is peeled off with a router, or the like, to be ready for soldering. In this state, characteristics, such as a reading distance as an RFID tag, and an influence of ambient wires, a casing, or the like, when assembled to a device are checked.

When an optimum position is determined on the basis of the result of checking of the characteristics, and the like, as shown in FIG. 30, the matching circuit 67 and a mounting portion for the electromagnetic coupling module 1 are formed at a position close to a position, at which the component 111 for a wireless IC device is assembled, within a ground electrode formation area on the printed wiring substrate 80, and then the electromagnetic coupling module 1 is mounted. By so doing, the main portion 6 of the wireless IC device is formed on the printed wiring substrate 80.

### Sixteenth Embodiment

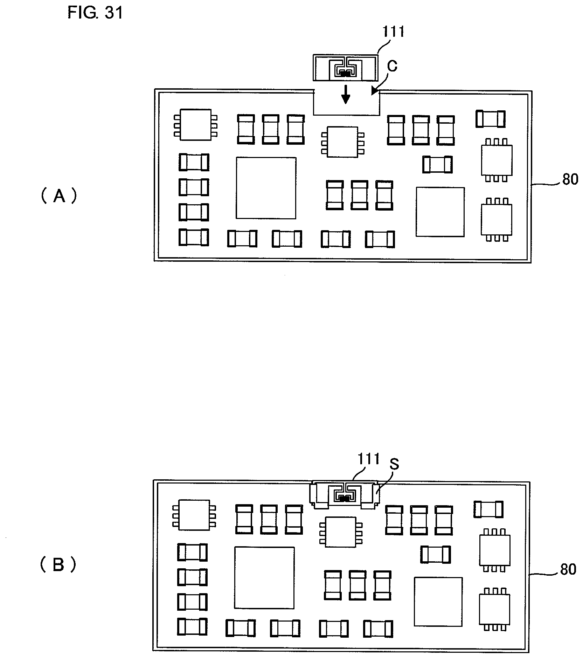

FIG. 31 are plan views that show the configuration of a component for a wireless IC device according to a sixteenth embodiment and the configuration of a wireless IC device provided with that component.

In this example, as shown in FIG. 31(A), the printed wiring substrate 80 has a cutout portion C formed at a position at which the component 111 for a wireless IC device is assembled, and then as shown in FIG. 31(B), the component 111 for a wireless IC device is assembled to the position through soldering. Soldering should be performed over the entire portions at which the electrodes contact.

With the above configuration, the state in which the component 111 for a wireless IC device is assembled is nearer to the final shape than that in the example shown in FIG. 29. Thus, further accurate design may be performed.

### Fifth Example

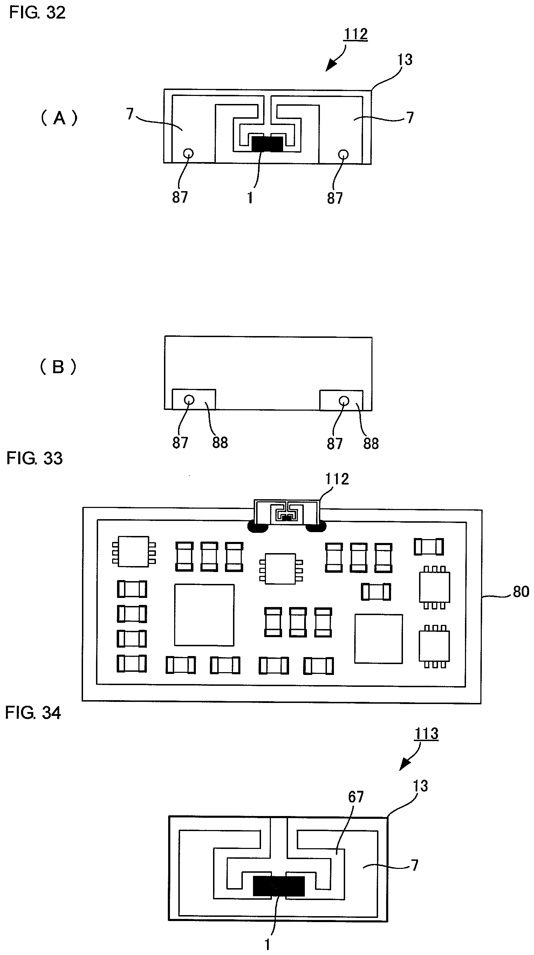

FIG. 32 are plan views that show the configuration of a component for a wireless IC device according to a fifth example. FIG. 33 is a plan view that shows the configuration of a wireless IC device provided with the component for a wireless IC device.

In this example, soldering electrode portions 88 are formed on the rear side of the component for a wireless IC device, and are connected to the loop electrode 7 on the front face via through-holes 87, or the like. As shown in FIG. 33, the soldering electrode portions 88 are soldered to the ground electrode of the printed wiring substrate 80.

In this way, by providing the soldering electrode portions 88 on the rear face, even when the position at which the ground electrode is formed does not spread to the edge of the printed wiring substrate 80, it may be easily mounted on the printed wiring substrate 80.

### Seventeenth Embodiment

FIG. 34 is a plan view that shows the configuration of a component 113 for a wireless IC device according to a seventeenth embodiment. A mounting portion, on which the electromagnetic coupling module 1 is mounted, the matching circuit 67, and the loop electrode 7 are formed on a printed wiring substrate 13, such as a glass epoxy substrate. The loop electrode 7 differs from the example shown in FIG. 28 in that the ends of the linear electrode are electrically connected to form a loop electrode.

The electromagnetic coupling module 1 is mounted on the printed wiring substrate 13 to form the component 113 for a wireless IC device. The component 113 for a wireless IC device, as in the case of the one shown in FIG. 29 or FIG. 31, is assembled to the printed wiring substrate.

In the component 113 for a wireless IC device, the loop electrode 7 is not influenced by a state of soldering, or the like, highly accurate design with less fluctuations in impedance, or the like, may be achieved. In addition, when it is used as an electronic component, variations in characteristic are small.

## Claims

1. An article comprising a wireless IC device comprising:
a wireless IC chip (5) connected to a loop-shaped electrode (7); the article further comprising a radiation electrode (8) which is configured to operate as a radiator, and is formed as a planar-shaped electrode having a cutout portion (62),
wherein an inner peripheral edge of the cutout portion (62) of the radiation electrode (8) faces the loop-shaped electrode (7) and is configured to be magnetically coupled to the loop-shaped electrode (7), wherein the cutout portion (62) is formed as non-conductive portion completely surrounded by the planar-shaped electrode and wherein the loop-shaped electrode (7) is arranged inside the non-conductive portion, wherein the area of the non-conductive portion is larger than the area occupied by the loop-shaped electrode (7), and the loop-shaped electrode (7) is located adjacent to the radiation electrode (8),
**characterized by**
the center of the loop-shaped electrode (7) being offset from the center of the non-conductive portion towards the inner peripheral edge.

2. The article according to Claim 1, wherein the radiation electrode (65) is a metal film layer of an article package such that a sheet having a conductive layer is formed into a bag-like shape or a package-like shape.

3. The article according to Claim 1, wherein the article is an electronic device, and wherein the radiation electrode (65) is an electrode pattern formed on a circuit substrate (80) in the electronic device.

4. The article according to Claim 1, wherein the article is an electronic device, and wherein the radiation electrode (65) is a metal plate provided on a rear face of a component in the electronic device.

5. The article according to Claim 1, wherein the article comprises a printed wiring substrate (80), and wherein the radiation electrode comprises a metal film (65) used as a ground electrode.

## Patentansprüche

1. Ein Artikel, der ein Drahtlos-IC-Bauelement aufweist, der folgende Merkmale aufweist:
einen Drahtlos-IC-Chip (5), der mit einer schleifenförmigen Elektrode (7) verbunden ist;
wobei der Artikel ferner folgendes Merkmal aufweist:
eine Strahlungselektrode (8), die konfiguriert ist, als ein Strahler zu arbeiten und als planar geformte Elektrode mit einem Ausschnittabschnitt (62) gebildet ist,
wobei ein Innenumfangsrand des Ausschnittabschnitts (62) der Strahlungselektrode (8) der schleifenförmigen Elektrode (7) zugewandt ist und konfiguriert ist, mit der schleifenförmigen Elektrode (7) magnetisch gekoppelt zu sein, wobei der Ausschnittabschnitt (62) als nicht leitfähiger Abschnitt gebildet ist, der von der planar geformten Elektrode vollständig umgeben ist, und wobei die schleifenförmige Elektrode (7) innerhalb des nicht leitfähigen Abschnitts angeordnet ist, wobei der Bereich des nicht leitfähigen Abschnitts größer als der Bereich ist, der durch die schleifenförmige Elektrode (7) eingenommen wird, und die schleifenförmige Elektrode (7) sich benachbart zu der Strahlungselektrode (8) befindet,
**dadurch gekennzeichnet, dass**
die Mitte der schleifenförmigen Elektrode (7) von der Mitte des nicht leitfähigen Abschnitts zu dem Innenumfangsrand hin versetzt ist.

2. Der Artikel gemäß Anspruch 1, bei dem die Strahlungselektrode (65) eine Metallfilmschicht eines Artikelgehäuses ist, sodass eine Lage mit einer leitfähigen Schicht in einer beutelartigen Form oder einer gehäuseartigen Form gebildet ist.

3. Der Artikel gemäß Anspruch 1, wobei der Artikel ein Elektronikbauelement ist und wobei die Strahlungselektrode (65) eine Elektrodenstruktur ist, die auf einem Schaltungssubstrat (80) in dem Elektronikbauelement gebildet ist.

4. Der Artikel gemäß Anspruch 1, wobei der Artikel ein Elektronikbauelement ist und wobei die Strahlungselektrode (65) eine Metallplatte ist, die auf einer Rückfläche einer Komponente in einem Elektronikbauelement vorgesehen ist.

5. Der Artikel gemäß Anspruch 1, wobei der Artikel ein gedrucktes Verdrahtungssubstrat (80) aufweist und wobei die Strahlungselektrode einen Metallfilm (65) aufweist, der als Masseelektrode verwendet wird.

## Revendications

1. Article comprenant un dispositif à circuit intégré sans fil comprenant :
une puce de circuit intégré sans fil (5) connectée à une électrode en forme de boucle (7) ; l'article comprenant en outre :
une électrode de rayonnement (8) qui est configurée pour fonctionner en tant que radiateur, et qui est formée en tant qu'électrode de forme plane comportant une partie découpée (62),
dans lequel un bord périphérique intérieur de la partie découpée (62) de l'électrode de rayonnement (8) est orienté vers l'électrode en forme de boucle (7) et est configuré pour être couplé magnétiquement à l'électrode en forme de boucle (7), dans lequel la partie découpée (62) est formée en tant que partie non conductrice entourée complètement par l'électrode de forme plane, et dans lequel l'électrode en forme de boucle (7) est agencée à l'intérieur de la partie non conductrice, dans lequel l'aire de la partie non conductrice est plus grande que l'aire occupée par l'électrode en forme de boucle (7), et l'électrode en forme de boucle (7) est située adjacente à l'électrode de rayonnement (8),
**caractérisé en ce que**
le centre de l'électrode en forme de boucle (7) est décalé par rapport au centre de la partie non conductrice vers le bord périphérique intérieur.

2. Article selon la revendication 1, dans lequel l'électrode de rayonnement (65) est une couche de film métallique d'un boîtier d'article telle qu'une feuille comportant une couche conductrice est formée en une forme similaire à un sac ou une forme similaire à un boîtier.

3. Article selon la revendication 1, dans lequel l'article est un dispositif électronique, et dans lequel l'électrode de rayonnement (65) est un motif d'électrode formé sur un substrat de circuit (80) dans le dispositif électronique.

4. Article selon la revendication 1, dans lequel l'article est un dispositif électronique, et dans lequel l'électrode de rayonnement (65) est une plaque métallique prévue sur une face arrière d'un composant dans le dispositif électronique.

5. Article selon la revendication 1, dans lequel l'article comprend un substrat de câblage imprimé (80), et dans lequel l'électrode de rayonnement comprend un film métallique (65) utilisé en tant qu'électrode de masse.
